# EUROPEAN PATENT APPLICATION

(11) **EP 4 597 498 A1**
(43) Date of publication of application: **06.08.2025**
(21) Application number: 25153306.3
(22) Date of filing: 22.01.2025
(51) Int. Cl.: G11C 5/04, G11C 5/06, H01L 23/00

(54) **METAL CONNECTOR IN SEMICONDUCTOR DEVICE PACKAGE**

(30) Priority: 01.02.2024 US 202418429723
(71) Applicant: Littelfuse, Inc., Rosemont, Illinois 60018 (US)
(72) Inventor: Spann, Thomas, Rosemont, 60018 (US); Lachmann, Thomas, Rosemont, 60018 (US)
(74) Representative: Arnold & Siedsma

(57) **Abstract**

A connector for a semiconductor device package. The connector may include a middle portion, having a curved concave shape in a front view, with respect to a given surface. The connector may include a first contacting portion, integrally connected to the middle portion on a first side, as wells as a second contacting portion, integrally connected to the middle portion on a second side, wherein the first contacting portion and the second contacting portion define a curved convex surface in the front view, with respect to the given surface. In some implementations, the connector may include a slot assembly as well as one or more indents that define a meander path, which structure imparts a greater elastic flexibility, such as under mechanical load.

## Description

### Background

### Field

The disclosure relates to the field of semiconductor devices, and in particular, packages for powering semiconductor chips.

### Discussion of Related Art

Semiconductor device packages (or simply, "semiconductor packages") such as power modules or discrete packages may include components such as semiconductor chips, substrates, and connectors, where the latter may include wires, clips, and other connectors. In particular, in power semiconductor packages, power chips may be included such as thyristors, field effect transistors (FETs), insulated gate bipolar transistors (IGBTs), and auxiliary chips, including diodes. A main purpose of clips is to electrically connect these chips to one another or to substrates. Such substrates may generally be formed as a sandwich structure with an inner insulating substrate such as alumina or aluminum nitride, and a layer of copper or aluminum on opposite main surfaces of the inner insulating substrate.

Metal clips provide an advantage over wire bonds for use as electrical connectors in that a single metal clip may proved substantially larger cross section to conduct electrical current as opposed to a wire. Moreover, wirebonding to attach wires to semiconductor chips or substrates may be more complex and less reliable as compared to attaching a metal clip to a substrate or semiconductor chip.

Known clips have been developed that have a pair of planar portions that are used to join to a chip surface or substrate surface. The planar portions of such clips are separated from one another by a middle portions that is curved. The overall structure of such a clip may exhibit a C-shape in front view, and such connectors may be referred to as "C-clips". This design may lower the stress buildup during mechanical load or thermos-mechanical load, thus increasing reliability of the C-clip connector during operation of the semiconductor package.

### Brief Summary

A connector for a semiconductor device package is provided. The connector may include a middle portion, having a curved concave shape in a front view, with respect to a given surface. The connector may include a first contacting portion, integrally connected to the middle portion on a first side. The connector may further include a second contacting portion, integrally connected to the middle portion on a second side, wherein the first contacting portion and the second contacting portion define a curved convex surface in the front view. with respect to the given surface.

A semiconductor device package is provided. The semiconductor device package may include a housing and a plurality of components, including at least one semiconductor chip, disposed within the housing. The semiconductor device package may also include a connector, preferably the connector referred to above, the connector being coupled to a pair of components of the plurality of components. The connector may include a middle portion, having a curved concave shape in a front view with respect to a given surface. The connector may also include a first contacting portion, integrally connected to the middle portion on a first side, and being affixed to a first component of the pair of components, and a second contacting portion, integrally connected to the middle portion on a second side, and being affixed to a second component of the pair of components. As such, the first contacting portion and the second contacting portion may define a curved convex surface in the front view, with respect to the given surface, wherein the connector provides an electrical connection between the pair of components.

### Brief Description of the Drawings

**FIG. 1A-1D** illustrate various views of a connector according to the present disclosure;
**FIG. 2A-2D** depict various views of a further connector according to the present disclosure;
**FIG. 3A-3D** shows various views of a connector according to the present disclosure;
**FIG. 4A-4D** shows various views of a connector according to the present disclosure;
**FIG. 5A-5D** show various views of a connector according to the present disclosure;
**FIG. 6** shows a side view of a semiconductor device package, arranged according to the disclosure;
**FIG. 7A** depicts the semiconductor device package of FIG. 6 in one configuration of warpage;
**FIG. 7B** depicts the semiconductor device package of FIG. 6 in another configuration of warpage;
**FIG. 8A** depicts an exemplary connector of the present disclosure in one configuration of warpage; and
**FIG. 8B** depicts the connector of FIG. 8A in another configuration of warpage.

### Description of Embodiments

The disclosure will now be described more fully hereinafter with reference to the accompanying drawings. In the drawings, like numbers refer to like elements throughout.

In the following description and/or claims, the terms "on," "overlying," "disposed on" and "over" may be used in the following description and claims. "On," "overlying," "disposed on" and "over" may be used to indicate that two or more elements are in direct physical contact with one another. Also, the term "on,", "overlying," "disposed on," and "over", may mean that two or more elements are not in direct contact with one another. For example, "over" may mean that one element is above another element while not contacting one another and may have another element or elements in between the two elements. Furthermore, the term "and/or" may mean "and", it may mean "or", it may mean "exclusive-or", it may mean "one", it may mean "some, but not all", it may mean "neither", and/or it may mean "both", although the scope of claimed subject matter is not limited in this respect.

A novel connector and a semiconductor device package are provided, as disclosed in the description to follow.

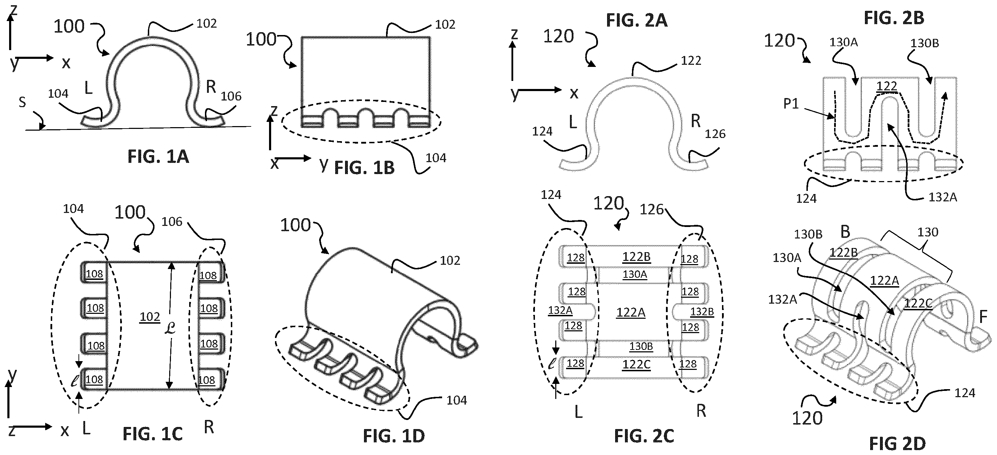

Turning to **FIG. 1A-1D** there are shown various views of a connector according to the present disclosure. In FIGs. 1A to 5D to follow, each figure with suffix "A" presents a front view of the relevant connector; each figure with suffix "B" presents a side view of the relevant connector; each figure with suffix "C" presents a top view of the relevant connector; and each figure with suffix "D" presents a perspective isometric view of the relevant connector.

In FIG. 1A the connector 100 is shown in front view, as noted. The connector 100 and other connectors disclosed may be formed of a highly conductive metal such as copper, copper alloy, or other conductive metallic material that is suitable for use as an electrical connector between components of a semiconductor device package, such as semiconductor chips and substrates. The connector 100 may be formed of a unitary or monolithic piece of sheet metal, which metal is shaped and cut to form the final structure, as shown. Generally, in a front view, as depicted in FIG. 1A, the connector 100 and other connectors to follow, may define a curved shape as shown, which shape may be referred to as an Omega-like shape, where "Omega-like" generally refers to the shape of the capital Greek letter Omega. The Omega-like shape of the connectors may be characterized by three different portions, defining three different curvatures, respectively. As shown, the connector 100 includes a middle portion 102, having a curved shape in front view, as well as a first contacting portion 104, integrally connected to the middle portion 102 on a first side, denoted by L. The connector 100 further includes a second contacting portion 106, integrally connected to the middle portion 102 on a second side, denoted by R. Note that the first contacting portion 104 and the second contacting portion 106 may define a curved surface in front view, as illustrated in FIG. 1A. In FIG 1A, the curved surface of the contacting portions (104, 106) is opposite to the curved surface of the middle portion 102, in that, if the curvature of middle portion 102 is deemed to be a concave curve (such as, with respect to a surface S), the curved surfaces of first contacting portion 104 and second contacting portion 106 may be deemed to be a convex curve.

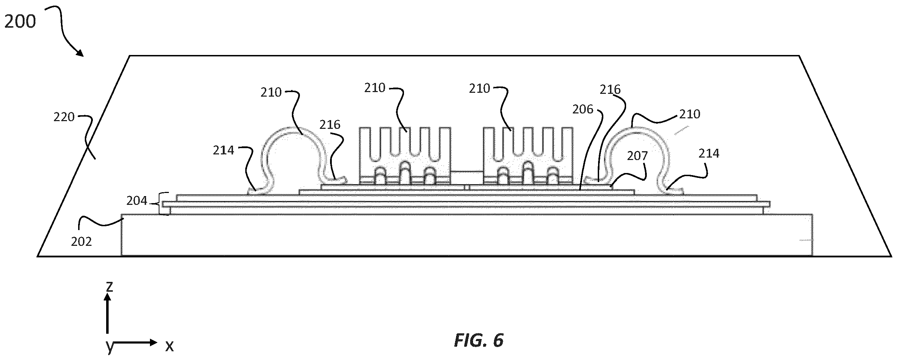

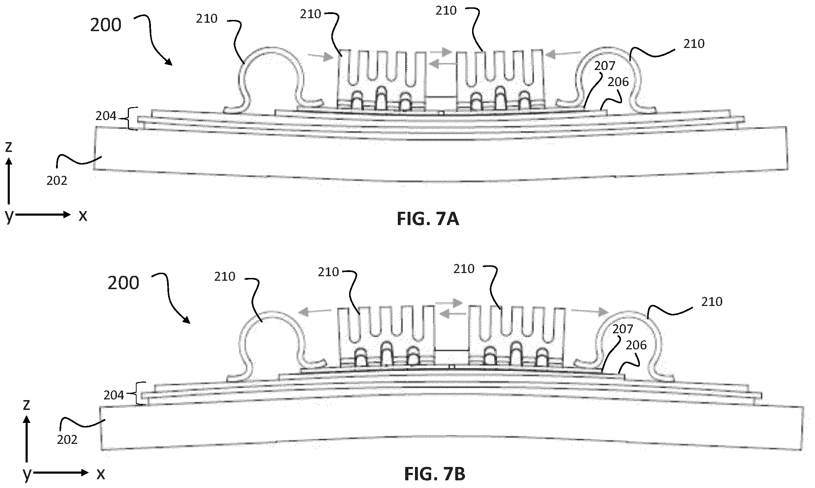

As further shown in FIGs. 1B-1D, the first contacting portion 104 and the second contacting portion 106 may include a plurality of fingers that extend from the middle portion 102. The plurality of fingers are shown as fingers 108, and as such, each of fingers 108 may define a curved shape in front view, as shown in FIG. 1A and FIG. 1D. Advantages of the structure conferred by the connector 100 are detailed with respect to FIGs. 6 and 7A-7B to follow. However, in brief, the structure of connector 100 provides improved thermo-mechanical stability under device operation in a semiconductor device package, as well as more less inherent strain within a connector after assembly in a package.

With reference to FIG. 1C, this and others to follow may arrange the fingers 108 or similar fingers with a relatively smaller length (along the Y-axis in the figure) shown as *l*, in comparison to the entire length L of the connector 100. For example, , the entire length L may be on the order of 1 cm, such as 0.5 cm, 1 cm, 2 cm. This arrangement ensures that the connector 100 will be attached to an external component just at the fingers 108, and thus the length of the interface between the external component and connector 100 is limited to the length *l*. For example, the length 1 may be on the order of 1 mm. By limiting the interface to a shorter interface as defined by I, the overall thermal mismatch strain generated between the connector 100 and the external component during temperature changes will be reduced. Moreover, the plurality of the fingers 108 as a whole present sufficient cross-sectional area for transporting a relatively higher electrical current across the connector 100.

**FIG. 2A-2D** depict various views of a further connector according to the present disclosure. As with the FIGs. 1A-1D, the connector 120 defines an Omega-like shape as viewed in front view. The connector 120 has a middle portion 122, a first contacting portion 124, and a second contacting portion 126. These contacting portions are also composed of a plurality of fingers, shown as fingers 128. A difference here is that the middle portion 122 includes a slot assembly 130 that extends between the first side (L) and the second side (R) and divides the middle portion 122 into a plurality of middle regions along a length of the connector. The slot assembly 130 is formed of two slots, shown as slot 130A and slot 130B, wherein the middle portion 122 is divided into middle regions that are composed of a center region 122A and two end regions, shown as end region 122B and end region 122C. These middle regions are arranged in sequence from one another along the length of connector 120 from front (F) to back (B) to form the middle portion 122 as a whole. The slot 130A and slot 130B provide an arrangement that allows the connector 120 to more readily elastically deform under mechanical load.

The center region 122A may further include a first indent 132A, disposed on the first side L, and a second indent 132B, disposed on the second side R. With respect to the Cartesian coordinate system shown, the slot assembly 130 and first indent 132A and second indent 132B impart stress absorbing properties to the connector 120 to reduce mechanical and thermo-mechanical stress in the X-, Y-, and Z- directions. In particular, the slot assembly 130 and indent 132A and indent 132B together serve to define a meander path, shown as P1, which structure allows for greater elastic deformation, such as under mechanical load.

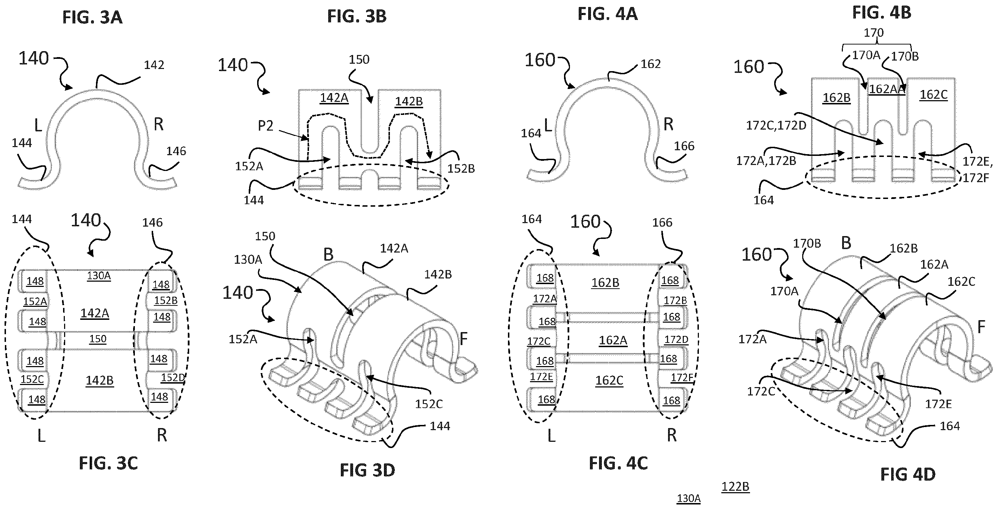

**FIG. 3A-3D** shows various views of a connector according to additional embodiments of the present disclosure. As with FIGs. 1A-1D, and FIGs. 2A-2D, the connector 140 defines an Omega-like shape as viewed in front view. The connector 140 has a middle portion 142, a first contacting portion 144, and a second contacting portion 146. These contacting portions are also composed of a plurality of fingers, shown as fingers 148. A difference is that the middle portion 142 includes a slot assembly 150, extending between the first side (L) and the second side (R), where the slot assembly 150 is a single slot that divides the middle portion 142 into an end region 142A and end region 142B. These regions are arranged in sequence from one another along the length of connector 140 from front (F) to back (B) to form the middle portion 142 as a whole.

End region 142A and end region 142B may each include a pair of indents: The end region 142A includes a side indent 152A, disposed on the first side L, and a side indent 152B, disposed on the second side R. The end region 142B includes a side indent 152C, disposed on the first side L, and a side indent 152D, disposed on the second side R. With respect to the Cartesian coordinate system shown, the slot assembly 150 and indents 152A-152D impart stress relieving properties to the connector 140 to reduce mechanical and thermo-mechanical stress in the X-, Y-, and Z- directions. In particular, the slot assembly 150 and indents 152A-152D serve to define a meander path, shown as P2, which feature allows for greater elastic deformation, such as under mechanical load.

**FIG. 4A-4D** shows various views of a connector according to the present disclosure. As with FIGs. 1A-1D, FIGs. 2A-2D, and FIGs. 3A-3D, the connector 160 defines an Omega-like shape as viewed in front view. The connector 160 has a middle portion 162, a first contacting portion 164, and a second contacting portion 166. These contacting portions are also composed of a plurality of fingers, shown as fingers 168. The middle portion 162 may include a slot assembly 170, extending between the first side (L) and the second side (R), where the slot assembly 170, like FIG. 2A, is formed of two slots, shown as slot 170A and slot 170B, wherein the middle portion 162 is divided into a center region 162A and two end regions, shown as end region 162B and end region 162C. These middle regions are arranged in sequence from one another along the length of connector 160 from front (F) to back (B) to form the middle portion 162 as a whole.

With respect to FIG 2A, the center region 162A may be relatively narrower and the end regions 162B, 162C may be relatively wider. Moreover, a first slot, slot 170A, may be aligned with a first pair of fingers located on the first contacting portion 164 and the second contacting portion 166, respectively, and a second slot, slot 170B, may be aligned with a second pair of fingers of the first contacting portion 164 and the second contacting portion 166.

In addition, each of the center region 162A, end region 162B, and end region 162C includes a pair of indents: The end region 162B includes an indent 172A, disposed on the first side L, and an indent 172B, disposed on the second side R. The center region 162A includes an indent 172C, disposed on the first side L, and an indent 172D, disposed on the second side R. The end region 162C includes an indent 172E, disposed on the first side L, and an indent 172F, disposed on the second side R. With respect to the Cartesian coordinate system shown, the slot assembly 170 and indents 172A-172F impart stress relieving properties to the connector 160 to reduce mechanical and thermos-mechanical stress in the X-, Y-, and Z- directions.

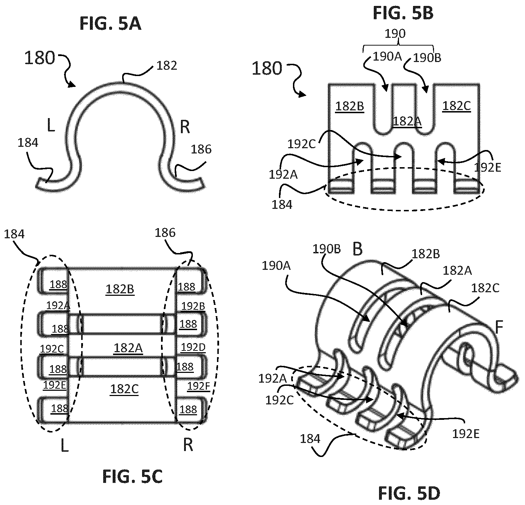

**FIG. 5A-5D** show various views of a connector according to the present disclosure. As with the embodiment of FIGs. 1A-1D, FIGs. 2A-2D, FIGs. 3A-3D, and FIGs. 4A-4D, the connector 180 defines an Omega-like shape as viewed in front view. The connector 180 has a middle portion 182, a first contacting portion 184, and a second contacting portion 186. These contacting portions are also composed of a plurality of fingers, shown as fingers 188. Here the middle portion 182 may include a slot assembly 190, extending between the first side (L) and the second side (R), where the slot assembly 190, as with FIG. 4A, may be formed of two slots, shown as slot 190A and slot 190B, wherein the middle portion 182 is divided into a center region 182A and two end regions, shown as end region 182B and end region 182C. These middle regions are arranged in sequence from one another along the length of connector 180 from front (F) to back (B) to form the middle portion 182 as a whole.

With respect to FIG 4B, here , the slots 190A, 190B are relatively wider than their counterparts of FIG. 4B. As with FIG. 4B, a first slot, slot 190A, is aligned with a first pair of fingers located on the first contacting portion 184 and the second contacting portion 186, respectively, and a second slot, slot 190B, is aligned with a second pair of fingers of the first contacting portion 184 and the second contacting portion 186.

In addition, each of the center region 182A, end region 182B, and end region 182C includes a pair of indents: The end region 182B includes an indent 192A, disposed on the first side L, and an indent 192B, disposed on the second side R. The center region 182A includes an indent 192C, disposed on the first side L, and an indent 192D, disposed on the second side R. The end region 182C includes an indent 192E, disposed on the first side L, and an indent 192F, disposed on the second side R. Note that the indents 192A, 192B are not centered with respect to end region 182B, and indents 192E, 192F are not centered with respect to end region 182B. With respect to the Cartesian coordinate system shown, the slot assembly 190 and indents 192A-192F impart stress relieving properties to the connector 180 to reduce mechanical and thermos-mechanical stress in the X-, Y-, and Z- directions.

**FIG.** 6 shows a side view of a semiconductor device package 200, arranged according to the disclosure. The semiconductor device package 200 may include a housing 218, and a plurality of components, including at least one semiconductor chip, shown as a chip 206, disposed within the housing 218. In the example shown, a baseplate 202 is provided, with a substrate 204, disposed on the baseplate. The substrate 204 may be a direct bonded copper (DCB) substrate for example, with a metallic layer disposed on an upper and lower surface of a ceramic body, as known in the art. Note that the semiconductor device package 200 may include a plurality of substrates, where just one substrate is shown for clarity of illustration. Likewise, in FIG. 6, just one semiconductor chip is shown, as chip 206, disposed on a top surface of substrate 204. In addition, there are shown a plurality of connectors 210 having a connector structure generally as disclosed. As shown, the connectors 210 may couple to the chip 206 through a contact layer 207, such as a copper tab. Two of connectors 210 are shown in front view, while two of connectors 210 are shown in side view. One side portion of the connectors 210 may be affixed to chips, such as chip 206, while another side portion is affixed to another component, such as substrate 204. In the example shown, for the connectors 210 that are shown in front view, a first contacting portion 214 is affixed to substrate 204, while a second contacting portion 216 is affixed to contact layer 207.

Note that because the upper surface of chip 206 is disposed above the upper surface of substrate 204 along the Z-direction, the connectors 210 may be rotated about the Y-axis with respect to the X-Z plane. Because the first contacting portion 214 and second contacting portion 216 have curved surfaces in the side view, the connectors 210 may be more readily affixed to substrate 204 and contact layer 207 without causing undue stress within the connector 210, chip 206, substrate 204, and bonding material (not separately shown) that is used to affix the connectors to substrate 204 and chip 206. Moreover, under operation the connectors 210 or similar connectors as arranged may better accommodate mechanical stress and thermos-mechanical stress that may be generated during use of the semiconductor device package. To illustrate this point, **FIG. 7A** depicts the semiconductor device package of FIG. 6 in one configuration of warpage, and **FIG. 7B** depicts the semiconductor device package of FIG. 6 in another configuration of warpage.

In the views of FIG. 7A and FIG. 7B, the side view of connectors 210 illustrates how the various slots, and indents may act to accommodate stresses in the X-, Y-, and Z- directions by providing space for deformation of regions of the connectors 210, so that these movements may reduce the stress that would otherwise be present at interfaces between the connector 210, chip 206, and substrate 204.

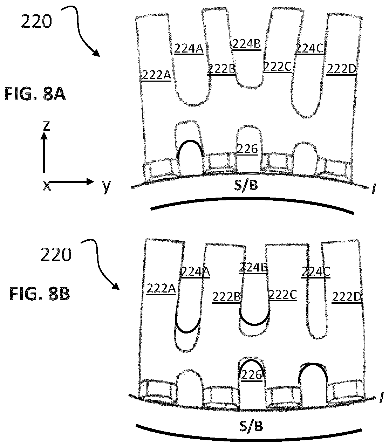

**FIG. 8A** depicts a close up view of an exemplary connector of the presentdisclosure , shown as connector 220, in one configuration of warpage, while **FIG. 8B** depicts the connector of FIG. 8A in another configuration of warpage. Because of the provision of slots 224A-224C, thus forming the regions 222A-222D, and the provision of indent 226, the regions 222A-222D are able to dislocate with respect to one another under conditions of warpage of a chip/substrate/baseplate (S/B) system that lies subjacent to the connector 220. In this manner, stress may be relieved at the interface I, for example, where electrical connection to the chip or substrate may take place. Note that the warpage shown in FIGs. 7A - 8B may be exaggerated for purposes of illustration, meaning the radius of curvature of the substrate or baseplate may be orders of magnitude larger than as shown in the figures, such that on the length scale of the connector, the given chip/substrate/baseplate is more planar than as shown.

In summary, the disclosure by providing novel connector structures configurations, to facilitate easier assembly of a connector structure, and more robust resistance to stresses, thus imparting a more reliable semiconductor device package. Note that, while the disclosure illustrates connectors having four fingers on a side, the length L of a connector may be longer or shorter, and may include fewer fingers/slots/indents or a greater number of fingers/slots/indents.

## Claims

1. A connector for a semiconductor device package, comprising:
a middle portion, having a curved concave shape in a front view, with respect to a given surface;
a first contacting portion, integrally connected to the middle portion on a first side; and
a second contacting portion, integrally connected to the middle portion on a second side,
wherein the first contacting portion and the second contacting portion define a curved convex surface in the front view. with respect to the given surface.

2. The connector of claim 1, wherein the connector defines an Omega-like shape in the front view.

3. The connector of claim 1 or 2, wherein the first contacting portion and the second contacting portion comprise a plurality of fingers that extend from the middle portion.

4. The connector of any of the claims 1-3, wherein the middle portion comprises a slot assembly that extends between the first side and the second side and divides the middle portion into a plurality of middle regions that are arranged with respect to one another along a length of the connector.

5. The connector of claim 4, wherein the slot assembly comprises two slots, wherein the middle portion is divided into a center region and two end regions.

6. The connector of claim 5, wherein the middle region further includes a first indent, disposed on the first side, and a second indent, disposed on the second side.

7. The connector of claim 4, wherein the slot assembly comprises a single slot, wherein the middle portion is divided into a first end region and a second end region.

8. The connector of claim 7, wherein the first end region includes a first side indent, disposed on the first side, and a second side indent, disposed on the second side, and wherein the second end region includes a third side indent, disposed on the first side, and a fourth side indent, disposed on the second side.

9. The connector of claim 5, wherein a first slot is aligned with a first pair of fingers of the first contacting portion and the second contacting portion, respectively, and wherein a second slot is aligned with a second pair of fingers of the first contacting portion and the second contacting portion.

10. A semiconductor device package, comprising:
a housing;
a plurality of components, including at least one semiconductor chip, disposed within the housing; and
a connector, preferably according to any of the preceding claims, the connector being coupled to a pair of components of the plurality of components, wherein the connector comprises:
a middle portion, having a curved concave shape in a front view with respect to a given surface;
a first contacting portion, integrally connected to the middle portion on a first side, and being affixed to a first component of the pair of components; and
a second contacting portion, integrally connected to the middle portion on a second side, and being affixed to a second component of the pair of components, and
wherein the first contacting portion and the second contacting portion define a curved convex surface in the front view, with respect to the given surface, wherein the connector provides an electrical connection between the pair of components.

11. The semiconductor device package of claim 10, with one or more of the following:
wherein the connector defines an Omega-like shape in the front view;
wherein the first contacting portion and the second contacting portion comprise a plurality of fingers that extend from the middle portion.

12. The semiconductor device package of claim 10 or 11, wherein the middle portion comprises a slot assembly that extends between the first side and the second side and divides the middle portion into a plurality of middle regions along a length of the connector.

13. The semiconductor device package of claim 12, wherein the slot assembly comprises two slots, wherein the middle portion is divided into a center region and two end regions, preferably
wherein the middle region further includes a first indent, disposed on the first side, and a second indent, disposed on the second side, or
wherein the slot assembly comprises a single slot, wherein the middle portion is divided into a first end region and a second end region, preferably
wherein the first end region includes a first side indent, disposed on the first side, and a second side indent, disposed on the second side, and wherein the second end region includes a third side indent, disposed on the first side, and a fourth side indent, disposed on the second side.

14. The semiconductor device package of claim 13, wherein the first slot is aligned with a first pair of fingers of the first contacting portion and the second contacting portion, respectively, and wherein the second slot is aligned with a second pair of fingers of the first contacting portion and the second contacting portion.

15. The semiconductor device package of any of the claims 10-14, the plurality of components further comprising a contact layer, disposed on the at least on semiconductor chip, wherein the first contacting portion of the connector is arranged in contact with the contact layer, preferably wherein the plurality of components further comprising a substrate, wherein the semiconductor chip is disposed on the substrate, and wherein the second contacting is arranged in contact with the substrate.
